# EUROPEAN PATENT APPLICATION

(11) **EP 2 565 938 A1**
(43) Date of publication of application: **06.03.2013**
(21) Application number: 11009532.0
(22) Date of filing: 01.12.2011
(51) Int. Cl.: H01L 31/048, H01L 31/052

(54) **Solar cell module**

(30) Priority: 05.09.2011 KR 20110089588
(71) Applicant: LG Electronics Inc., Youngdungpo-gu, Seoul 150-721 (KR)
(72) Inventor: Kim, Taeyoon, Seoul, 137-724 (KR); Yu, Jemin, Seoul, 137-724 (KR); Lee, Eunjoo, Seoul, 137-724 (KR); Mun, Seiyoung, Seoul, 137-724 (KR); Hong, Jongkyoung, Seoul, 137-724 (KR); Woo, Taeki, Seoul, 137-724 (KR)
(74) Representative: Katérle, Axel

(57) **Abstract**

A solar cell module includes a plurality of solar cells, a light transparent front substrate disposed on front surfaces of the plurality of solar cells (10), a back substrate (40) disposed on back surfaces of the plurality of solar cells, a sealing member (50) disposed between the light transparent front substrate and the back substrate, and having at least one layer of a sealing material. The back substrate and the sealing member may contain silicon-based materials, respectively.

## Description

### BACKGROUND OF THE INVENTION

### (a) Field of the Invention

Embodiments of the invention relate to a solar cell module.

### (b) Description of the Related Art

Solar photovoltaic power generation transforms solar energy to electric energy using photoelectric transformation effect. Such solar photovoltaic power generation has been used as a mean for obtaining clean energy. The photoelectric transformation efficiency of a solar cell has been improved dramatically. Lately, many private houses have been built with a solar photovoltaic power generation system including a plurality of solar cell modules.

A solar cell module includes a plurality of solar cells that generate electric power by solar light. Such a solar cell module includes protective layers disposed on a front surface and a back surface of the solar cells in order to protect the solar cells from external environments such as impact and moisture.

### SUMMARY OF THE INVENTION

In accordance with an embodiment of the invention, a solar cell module includes a plurality of solar cells, a light transparent front substrate disposed on front surfaces of the plurality of solar cells, a back substrate disposed on back surfaces of the plurality of solar cells, and a sealing member disposed between the light transparent front substrate and the back substrate and having at least one layer of a sealing material. The back substrate and the sealing member may contain silicon-based materials, respectively.

The back substrate may be made of a first silicone resin and the sealing member may be made of a second silicone resin. Particularly, the back substrate may be made of organopolysiloxane and the sealing member may be made of one of polydimethylsiloxane (PDMS) or polydialkylsiloxane (PDAS).

The back substrate may have a tensile strength higher than about 30MPa.

The back substrate may have a light transmittance lower than about 50% for wavelengths of light of about 300nm to about 500nm, and have light reflectance higher than about 40% for wavelengths of light of about 300nm to 500nm. The back substrate may have white pigment.

At least one of the sealing member and the back substrate may further include a fiber material. The fiber material may include fibers formed in a mesh shaped structure, and the fibers may be at least one of glass fibers, graphite fibers, nylon fibers, polyester fibers, aramid fibers, polyethylene fibers, polypropylene fibers, and silicon carbide fibers.

A space between the fibers of the fiber material may be filled with the second silicone resin of the sealing member, be filled with the first silicone resin of the back substrate, or be filled with the second silicone resin of the sealing member and the first silicone resin of the back substrate.

The fiber material may be disposed inside the sealing member, inside the back substrate, between the sealing member and the back substrate, or on the back substrate.

A contact surface between the sealing member and the back substrate may be an uneven surface. The sealing member may include a first sealing material disposed between the front substrate and the plurality of solar cells, and a second sealing material disposed between the plurality of solar cells and the back substrate. A contact surface of the first sealing material and the second sealing material may be an uneven surface.

The back substrate may contain a white pigment, and the sealing member may contain a smaller amount of the white pigment than that contained in the back substrate.

Since the sealing member and the back substrate are made of the same material, for example, silicon material, the adhesive strength between the sealing member and the back substrate may be greater than that between a sealing member and a back substrate, which are made of different materials.

For example, the adhesive strength between a sealing member formed of silicone resin and a back substrate formed of Tedlar material or PET material is about 10kg/cm² to 15kg/cm² when the back substrate is taken off in a vertical direction. However, the adhesive strength between the sealing member 50 made of silicone resin and the back substrate 40 made of silicone resin is greater than about 15kg/cm². Accordingly, the adhesive strength may be improved.

Therefore, it may effectively prevent moisture, oxygen, and impurity from being penetrated through the interface between the sealing member and the back substrate for a comparatively long time. Therefore, the reliability of the solar cell module may be improved.

The silicone resin of the sealing member may have a higher light transmittance for short wavelength band, such as ultraviolet ray wavelength, than that of a typical sealing member made of EVA or PVB. For example, the silicone resin of the sealing member may have about 80% of light transmittance for ultraviolet ray wavelength.

Silicone resin of the back substrate may have 50% of light transmittance for short wavelengths from about 300nm to about 500nm. For example, the light transmittance of the silicone resin of the back substrate may be lower than about 20% for short wavelengths from about 300nm to about 500nm. Furthermore the light transmittance of the silicone resin of the back substrate may be lower than about 30% for short wavelengths from about 200nm to about 1200nm.

Light reflectivity thereof is greater than about 40% for short wavelength, and light reflectivity thereof is greater than about 50% for short wavelengths from 200nm to 1200nm.

Accordingly, decolorization problem of the sealing member may be suppressed, and an amount of light entering to solar cells may be increased, thereby improving the output of the solar cell module.

The silicone resin can be formed at a thinner thickness than that of EVA which is used as a typical sealing member. Therefore, overall thickness of the solar cell module can be reduced.

When the back substrate is formed of typical Tedlar material or PET material, a back substrate cutting process is required to extract a bus bar ribbon. However, such an addition process for extracting a bus bar ribbon is not required when the back substrate is made of silicone resin because the back substrate is formed by coating and hardening silicone resin in liquid state.

The back substrate made of silicone resin has heat conductivity greater than that of a back substrate made of typical material such as Tedlar or PET. Therefore, heat generated in the solar cell module can be effectively released.

When an interface between the first and second sealing materials and/or an interface between the sealing material and the back substrate is formed as an uneven surface, light entering through the front substrate is diffusely reflected at the interfaces. Accordingly, an amount of light entering to the solar cells may be increased, and the output of the solar cell module may be improved.

Since the fiber material is disposed inside the sealing material, inside the back substrate, or between the sealing material and the back substrate, the strength of the solar cell module may be increased due to the fiber material. Accordingly, the solar cell module can be protected from being cracked. Furthermore, distortion of the silicone resin may be prevented during a lamination process, and the leveling of a back surface of the back substrate may be improved.

A space between fibers of a mesh shaped fiber material may be filled with silicone resin of the sealing material or silicone resin of the back substrate. Therefore, parts may be firmly bonded with each other in the solar cell module.

Since the fiber material reflects light, the efficiency of the solar cell may be improved by the reflected light.

Since the silicone resin has a low hardening temperature, a modularization process may be carried out at a comparatively low temperature, and a hardening duration may be shortened.

### BRIEF DESCRIPTION OF THE DRAWINGS

FIG. 1 illustrates a solar cell module in accordance with a first embodiment of the invention.

FIG. 2 is a graph illustrating extinction coefficients of a silicone resin and ethylene vinyl acetate (EVA) according to wavelength of light.

FIG. 3 is an enlarged view of a "C" part of FIG. 1.

FIG. 4 is an enlarged view of a "D" part of FIG. 1

FIG. 5 is an enlarged view of an "E" part of FIG. 1.

FIG. 6 is a cross sectional view of a solar cell used in a solar cell module, in accordance with an embodiment of the invention.

FIG. 7 illustrates a method of forming a solar cell module of FIG. 1.

FIG. 8 illustrates a solar cell module in accordance with a first modified embodiment of FIG. 1.

FIG. 9 illustrates a solar cell module in accordance with a second modified embodiment of FIG. 1.

FIG. 10 illustrates a solar cell module in accordance with a second embodiment of the invention.

FIG. 11 illustrates a method of forming a solar cell module of FIG. 10.

FIG. 12 illustrates a solar cell module in accordance with a third embodiment of the invention.

FIG. 13 illustrates a method of forming a solar cell module of FIG. 12.

FIG. 14 illustrates a solar cell module in accordance with a fourth embodiment of the invention.

FIG. 15 illustrates a solar cell module in accordance with a fifth embodiment of the invention.

FIG. 16 illustrates a solar cell module in accordance with a sixth embodiment of the invention.

### DETAILED DESCRIPTION OF THE EMBODIMENTS

In the following detailed description, certain exemplary embodiments of the invention have been shown and described, simply by way of illustration. As those skilled in the art would realize, the described embodiments may be modified in various different ways, all without departing from the spirit or scope of the invention. Accordingly, the drawings and description are to be regarded as illustrative in nature and not restrictive. Like reference numerals designate like elements throughout the specification.

In the drawings, the thickness of layers is exaggerated for clarity. It will be understood that when an element such as a layer, film, region or substrate is referred to as being "on" another element, it can be directly on the other element or intervening elements may also be present. In contrast, when an element is referred to as being "directly on" another element, there are no intervening elements present.

Additionally, when an element is referred to as being "formed entirely on" another element, it can be formed on an entire surface of another element or it can be not formed on edges of another elements.

Hereinafter, a solar cell module in accordance with an embodiment of the invention will be described with reference to the accompanying drawings.

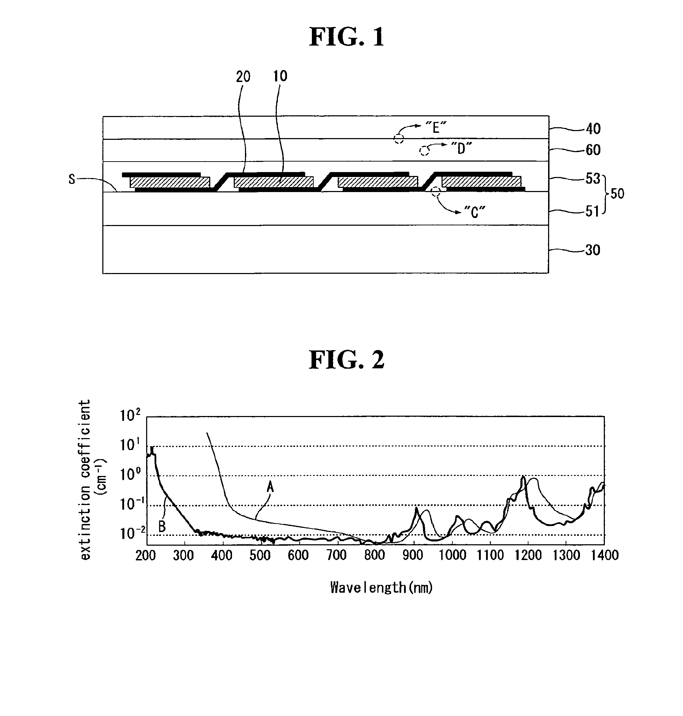

FIG. 1 illustrates a solar cell module in accordance with an embodiment of the invention.

Referring to FIG. 1, the solar cell module in accordance with an embodiment of the invention may include a plurality of solar cells 10, interconnectors 20, a light transparent front substrate 30, a back substrate 40, and a sealing member 50. The interconnectors 20 may electrically connect the plurality of solar cells 10. The light transparent front substrate 30 may be disposed on a front surface of the solar cells 10. The back substrate 40 may be disposed on a back surface of the solar cells 10. The sealing member 50 may be disposed between the front substrate 30 and the back substrate 40.

The light transparent front substrate 30 may be disposed on a first surface of the solar cell 10. For example, the first surface may be a light receiving surface of the solar cell 10. The light transparent front substrate 30 may be made of, for example, a tempered glass having high transmittance. The tempered glass may be a low iron tempered glass containing a small amount of iron. Such a light transparent front substrate 30 may have a textured inner surface in order to improve a light dispersion effect.

The sealing member 50 may include a first sealing material 51 and a second sealing material 53. The first sealing material 51 may be disposed between the solar cell 10 and the front substrate 30, and the second sealing material 53 may be disposed between the solar cell 10 and the back substrate 40. The sealing member 50 may prevent penetration of moisture so as to protect inner parts thereof from metal corrosion. Furthermore, the sealing member 50 may protect the solar cells 10 from impact. The sealing member 50 contains a silicon-based material.

The first sealing material 51 may be made of a first silicone resin that transmits 80% of light having wavelengths from about 300nm to about 500nm. The first silicone resin may have an adhesive strength of about 10kg/cm² to about 15kg/cm² with the light transparent front substrate 30. The first sealing material 51 may be formed by coating a liquid first silicone resin on the light transparent front substrate 30 and hardening the coated liquid first silicone resin.

The first silicone resin of the first sealing material 51 may be siloxane, for example, polydimethylsiloxane (PDMS) or polydialkylsiloxane (PDAS).

FIG. 2 illustrates extinction coefficients (cm⁻¹) of a first silicone resin and ethylene vinyl acetate (EVA) according to a wavelength of light.

Referring to FIG. 2, a graph "A" shows extinction coefficients of EVA, which are changed according to a wavelength. A graph "B" shows extinction coefficients of the first sealing material 51, which are changed according to a wavelength.

EVA used in this instance is a typical material used as a sealing member of a solar cell. The first silicone resin used for the graph B may be polydimethylsiloxane (PDMS).

As shown in FIG. 2, the extinction coefficient of EVA is higher than that of PDMS at short wavelengths, for example, about 300nm to 500nm. Accordingly, the first silicone resin has light absorbance lower than that of EVA at short wavelengths.

Meaning, the first silicone resin may more easily transmit short wavelength light because the first silicone resin has low light absorbance at the short wavelength. The first silicone resin may have light transmittance that transmits 80% of short wavelength light. The first silicone resin may be siloxane such as polydimethylsiloxane (PDMS) or polydialkylsiloxane (PDAS).

Accordingly, when the first sealing material 51 is made of the first silicone resin, an amount of light absorbed into the first sealing material 51 may be reduced. As a result, an amount of light entering to the inside of the solar cell 10 may be increased. Therefore, an output efficiency of the solar cell module may be improved.

Furthermore, the first silicone resin may suppress a decolorization problem and a corrosion problem of the first sealing material 51, which may be caused by air or oxygen. Therefore, the first silicone resin may increase durability of the solar cell module.

The first sealing material 51 can be formed at a thinner thickness as compared to EVA that is commonly used as a typical protective layer. Therefore, overall thickness of a solar cell module may be reduced too.

For example, a protective layer made of EVA is formed at a thickness of about 1.0mm. The first sealing material 51 can be formed at a thickness thinner than about 0.7mm. For example the first sealing material 51 may be formed at a thickness of about 0.3mm to about 0.5mm. Therefore, an overall thickness of the solar cell module may be reduced as compared to a typical solar cell module.

Furthermore, a hardening temperature of the first silicone resin is lower than that of EVA. Accordingly, a modularization process can be performed at a comparatively lower temperature and a hardening duration may be shortened.

For example, the first silicone resin may be hardened at a temperature higher than about 80°C, for example, at about 90°C to about 150°C, while EVA may be hardened at about 165°C. Accordingly, the modularization process may be performed at a comparatively lower temperature.

About 1.5 minutes may be required to harden the first silicone resin. However, about 16 minutes may be required to harden the EVA. Accordingly, a time consumed for hardening a protective layer and for a modularization process can be shortened.

The second sealing material 53 may be formed of a second silicone resin. The second sealing material 53 may be formed of a resin having a lower light transmittance at a short wavelength, as compared to that of the first sealing material 51.

The second silicone resin of the second sealing material 53 may have a lower light transmittance of a short wavelength, as compared to that of the first silicone resin of the first sealing material 51.

The second sealing material 53 may be formed at a thickness of about 0.3mm to about 0.5mm, which is about the same to the thickness of the first sealing material 51.

However, the second sealing material 53 may be thicker than the first sealing material 51 in order to improve weatherproof property of the solar cell module.

Since the light transmittance of the second sealing material 53 is lower than that of the first sealing material 51, a part of short wavelength light that passes through the first sealing material 51 does not penetrate through the second sealing material 53.

Accordingly, the second sealing material 53 may prevent the back substrate 40 from decolorization and deterioration caused by the short wavelength light penetrating through the second sealing material 53. In this instance, the back substrate 40 may be a back sheet.

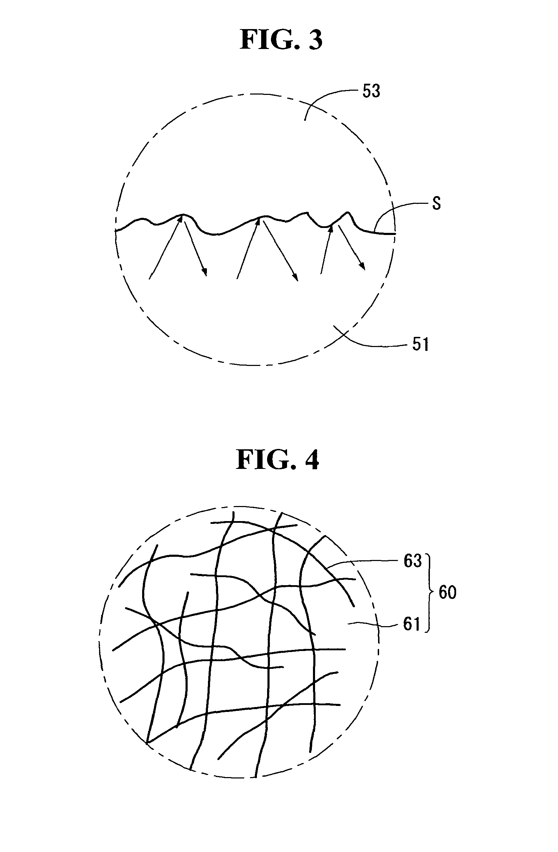

An interface S between the first and second sealing materials 51 and 53 may be formed as an uneven surface as shown in an enlarged view shown in of FIG. 3. The uneven surface may be referred to a surface having a plurality of concaves and convexes.

The reason of forming the interface S between the first and second sealing materials 51 and 53 as the uneven surface is to form the second sealing material 53 on the first sealing material 51. For example, the first sealing material 51 may be formed by hardening coated liquid first silicone resin at a predetermined temperature. After forming the first sealing material 51, the second sealing material 53 may be formed on the first sealing material 51 by hardening the second silicone resin coated on the first sealing material 51 at a predetermined temperature.

Since the interface S between the first and second sealing materials 51 and 53 is an uneven surface, light penetrating through the first sealing material 51 is diffusely reflected on the interface S as shown by arrows of FIG. 3. Accordingly, an amount of light entering the solar cells may be increased.

In the same manner, an interface between the second sealing material 53 and the back substrate 40 may be formed as an uneven surface. The reason of forming the interface as the uneven surface is to form the back substrate 40 on the second sealing material 53. For example, the second sealing material 53 may be formed by hardening the second silicone resin coated on the first sealing material 51. After forming the second sealing material 53, the back substrate 40 may be formed on the second sealing material 53 and fiber material 60 by coating a liquid third silicone resin on the second sealing material 53 and fiber material 60 and hardening the third silicone resin at a predetermined temperature.

Light is diffusely reflected at the interface between the second sealing material 53 and the back substrate 40. Therefore, an amount of light entering a solar cell may be increased.

The plurality of solar cells 10 may be disposed on the first sealing material 51 as shown in FIG. 1. That is, the plurality of solar cells 10 may be disposed on the interface S between the first sealing material 51 and the second sealing material 53. Accordingly, sides and tops of the solar cells may be covered by the second sealing material 53.

The back substrate 40 contains a silicon-based material. Especially, the back substrate 40 may be formed of a third silicone resin containing organopolysiloxane as a main component. The third silicone resin may contain a hardener. A weight ratio of the hardener in the third silicone resin may be greater than about 50% of an overall weight ratio of the third silicone resin.

The third silicone resin may be formed by adding reinforcement material, such as a powder filler, to the main component, by adding a functional group to the main component, or by alternately using different main components with a hardener in order to improve a crosslinking density of the hardener.

The back substrate 40 made of the third silicone resin may have a tensile strength of about 10 times greater than that of the sealing member 50. For example, the back substrate 40 may have a tensile strength of about 30MPa. Furthermore, the back substrate 40 may have a light transmittance that transmits less than 50% of wavelengths of about 300nm to about 500nm. The back substrate 40 may have about 40% of light reflectivity. In order for the back substrate 40 to have the light transmittance and the light reflectivity within the above described ranges, white pigment may be dispersed in the third silicon resin of the back substrate 40.

In order to have the light transmittance and the light reflectivity within a proper range, white pigment may be included in the first sealing member 51 and/or the second sealing member 53 similar to the back substrate 40. Particularly, the first sealing member 51 may contain a smaller amount of white pigment than that of the second sealing member 53. The second sealing member 53 may contain a smaller amount of white pigment than that of the back substrate 40.

The solar cell module in accordance with an embodiment of the invention may further include a fiber material 60.

The fiber material 60 may include a plurality of fibers 63 each separated from others by a space 61, as shown in an enlarged view shown in FIG. 4. The fiber material 63 may be formed in a shape of a mesh.

The fiber material 60 may be disposed closer to the back substrate 40 than the solar cells. For example, the fiber material 60 may contact the back substrate 40 as shown in FIG. 1.

Since the fiber material 60 is formed in a shape of a mesh, the space 61 of the fiber material 60 may be filled with the second silicone resin that forms the second sealing material 53. In FIG. 4, the space 61 is filled with the second silicone resin. That is, the space 61 of the fiber material 60 is filled with the second sealing material 53.

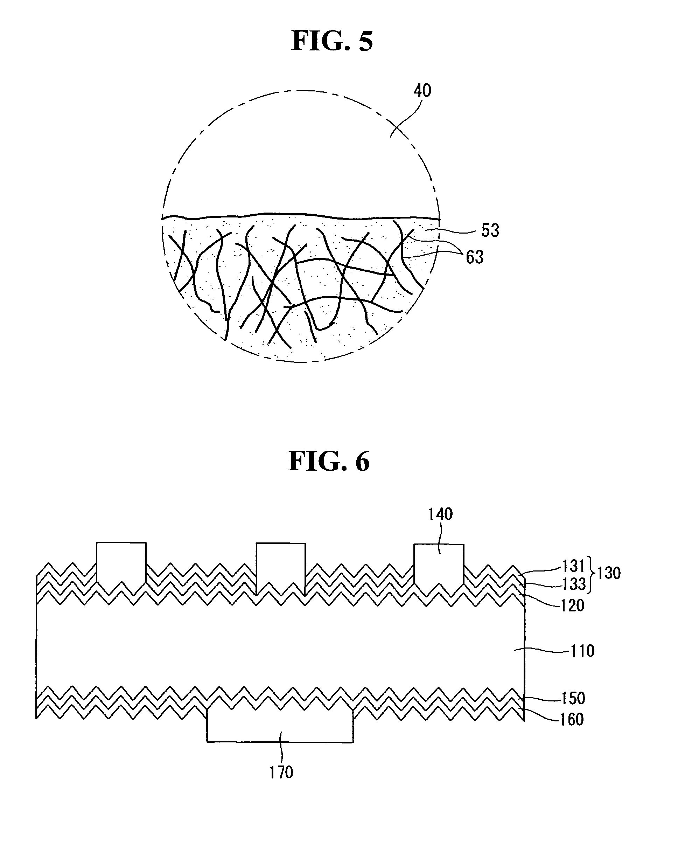

FIG. 5 is an enlarged view of an "E" part of FIG. 1. FIG. 5 illustrates that at least one part of the fiber material 60 is separated from the back substrate 40.

As shown in FIG. 5, at least one part of the fiber material 60 may be separated from the back substrate 40. In this instance, the space 61 of the fiber material 60 and the space between the fiber material 60 and the back substrate 40 may be filled with the second sealing material 53.

Accordingly, the second sealing material 53 may contact the back substrate 40 when at least one part of the fiber material 60 is separated from the back substrate 40 and when the entire parts of the fiber material 60 contact the back substrate 40.

The fiber material 60 may be formed of glass fiber. For example, the fiber material 60 may be a style 106 glass fiber fraction that may be produced by BGF industries. The style 106 glass fiber fraction may have a size of about 8inch x 8inch (about 20.32cm x about 20.32cm). However, the fiber material 60 is not limited to the glass fiber.

For example, the fiber material 60 may be formed of reinforcement material having glass fiber, quartz fiber, graphite fiber, nylon fiber, polyester fiber, aramid fiber of Kevlar^{®} and Nomex^{®}, polyethylene fiber, polypropylene fiber, and silicon carbide fiber. However, embodiments of the invention are not limited thereto.

The fiber material 60 may be formed thinner than the first sealing material 51 and the second sealing material 53. For example, the fiber material 60 may be formed at a thickness from about 0.3mm to about 0.5mm.

When the fiber material 60 is disposed between the second sealing material 53 and the back substrate 40, the fiber material 60 may increase the strength of the solar cell module, thereby preventing or reducing the solar cell module from being cracked. The fiber material 60 may also prevent or reduce distortion of the second sealing material 53 while hardening the second silicone resin. Accordingly, a leveling of the back substrate 40 may become improved.

Furthermore, the efficiency of the solar cell module may be improved due to the reflection effect of the fiber material 60 because the fiber material 60 may reflect light not absorbed in the solar cells. When the fiber material 60 is disposed closer to the back substrate 40 than the solar cells 10, an amount of light entering to the fiber material 60 is increased, as compared to when the fiber material 60 is disposed closer to the solar cells 10. Accordingly, the reflection effect of the fiber material 60 may be increased and the efficiency of the solar cell 10 may be further improved.

Since the sealing member 50 and the back substrate 40 may be formed of silicone resin, an adhesive strength between the sealing member 50 and the back substrate 40 is greater, as compared to when the sealing member 50 and the back substrate 40 are formed of different materials.

For example, the sealing member 50 may be formed of silicone resin and the back substrate 40 may be formed of Tedlar material or PET material. In this instance, adhesive strength of the back substrate is about 10kg/cm² to 15kg/cm² when the back substrate is taken off in a vertical direction. When the sealing member 50 and the back substrate 40 are formed of silicone resin, the adhesive strength of the back substrate is greater than about 15kg/cm².

The fiber material may effectively prevent moisture, oxygen, and impurity from being penetrated through the interface between the sealing member 50 and the back substrate 40 for a comparatively long time. Therefore, the reliability of the solar cell module may be improved.

The third silicone resin forming the back substrate 40 may have a light transmittance that transmits about 50% of short wavelength light. For example, the third silicone resin may transmit less than about 20% of short wavelength light. Particularly, the third silicone resin may transmit less than 30% of short wavelengths of about 200nm to about 1200nm. The third silicone resin may have a light reflectivity higher than about 40% for short wavelength light. For example, the third silicone resin may have a light reflectivity higher than about 50% for short wavelength of about 200nm to about 1200nm.

In order to reduce the light transmittance of the back substrate 40 and increase the light reflectivity of the back substrate 40, white pigment may be dispersed in the third silicone resin. Particularly, a greater amount of white pigment may be dispersed in the third silicon resin than that dispersed in the second sealing member 53.

Accordingly, an amount of light entering the solar cells 10 may be increased, thereby improving the output of the solar cell module.

Since the back substrate is formed by coating a liquid third silicone resin and hardening the liquid third silicone resin, an addition process for extracting a bus bar ribbon may not be necessary.

The back substrate formed of the silicone resin has heat conductivity higher than that of a back substrate made of Tedlar or PET material. Accordingly, heat generated in the solar cell module may be effectively released.

FIG. 6 illustrates a solar cell useable with a solar cell module in accordance with an embodiment of the invention. However, embodiments of the invention are not limited thereto. Solar cells having various shapes and configurations may be used for the solar cell module in accordance with an embodiment of the invention.

The solar cell 10 may include a substrate 110, an emitter 120, a first antireflection layer 130, a first electrode 140, a back surface field (BSF) unit 150, a second antireflection layer 160, and a second electrode 170. The emitter 120 may be disposed on one side of the substrate 110, for example, a front surface of the substrate 110. The first antireflection layer 130 may be disposed on the emitter 120. The first electrode 140 may be disposed on a region of the emitter 120 where the first antireflection layer 130 is not located. The BSF unit 150 may be disposed on the back surface of the substrate 110. The second antireflection layer 160 may be disposed on the back surface of the BSF unit 150. The second electrode 170 may be disposed on a back surface of the BSF unit 150, where the second antireflection layer 160 is not disposed.

The substrate 110 may be formed of a first conductive type silicon wafer, for example, an n conductive type silicon wafer. The silicon may be single crystalline silicon, polycrystalline silicon, or amorphous silicon.

When the substrate 110 is of the n conductive type, the substrate 110 may contain impurities of Group V elements such as phosphorus (P), arsenic (As), and antimony (Sb). The substrate may have a specific resistance of about 1Ω·cm² to about 10Ω·cm².

Alternatively, the substrate 110 may be of a p conductive type. The substrate 110 may be formed of other semiconductor materials instead of silicon.

When the substrate 110 is of the p conductive type, the substrate 110 may contain impurities of Group III elements such as boron (B), gallium (Ga), and indium (In).

Such a substrate 110 may have a textured surface on at least one of a front surface and a back surface thereof.

The emitter 120 may be disposed on the front textured surface of the substrate 110. The emitter 120 may be of a second conductive type that is opposite to a conductive type of the substrate 120. For example, the emitter 120 may have p conductive type impurities, thereby forming a p-n junction with the substrate 110.

The p-n junction generates a built-in potential difference. Due to the built-in potential difference, electro-hole pairs, which are electric charges generated by light entering to the substrate 110, is separated into electrons and holes. The electrons may move toward the n conductive type semiconductor, and the holes may move toward the p conductive type semiconductor.

When the substrate 110 is the n conductive type and the emitter 120 is the p conductive type, the separated electrons may move toward the substrate 110 and the separated holes may move toward the emitter 120. Therefore, electrons may become majority carriers in the substrate 110 and holes may become majority carriers in the emitter 120.

When the emitter 120 is the p conductive type, the emitter 120 may be doped with Group III elements such as boron (B), gallium (Ga), and indium (In). The emitter 120 may have a surface resistance of about 30Ω/sq to about 120Ω/sq.

When the substrate 110 is the p conductive type, the emitter 120 may be the n conductive type. In this instance, the separated holes may move toward the substrate 110, and the separated electrons may move toward the emitter 120.

When the emitter 120 is the n conductive type, the emitter 120 may be formed by doping the substrate 110 with Group V elements such as phosphorus (P), arsenic (As), antimony (Sb).

The first antireflection layer 130 may be formed on the emitter 120. The first antireflection layer 130 may include a metal oxide material.

For example, the first antireflection layer 130 may include a top layer 131 formed of silicon nitride (SiNx:H) (e.g., hydrogenated silicon nitride), and a bottom layer 133 disposed between the emitter 120 and the top layer 131.

The bottom layer 133 may be made of a material having an extinction coefficient or bandgap (Eg) significantly different from those of the silicon nitride layer. For example, the bottom layer 133 may be formed of aluminum oxide (A1Ox).

The first antireflection layer 130 having the bottom layer 133 may reduce reflectivity of light entering through the front surface of the substrate 130 and improve selectivity of specific wavelength. Furthermore, the first antireflection layer 130 may function as a passivation layer.

Meanwhile, the bottom layer 133 may be made of silicon oxide (SiOx: H) (e.g., hydrogenated silicon oxide) instead of the aluminum oxide.

The first antireflection layer 130 may include a plurality of contact lines exposing a part of the emitter 120. The first electrode 140 may be formed on the emitter 120 exposed through the contact lines.

The contact lines may be formed to have a width of about 20µm to about 60µm in order to form the first electrode 140 with a fine line width and a high aspect ratio. The contact lines may be formed to have about 2% plan area to about 6% plan area of the emitter 120. That is, the contact lines may cover about 2% to about 6% of a surface of the emitter 120.

When the contact line is formed to have the described line width, the first electrode 140 may be formed at a thickness of about 20µm to about 50µm using a plating process.

Accordingly, the first electrode 140 may have a high aspect ratio, for example, an aspect ratio of about 0.83 to about 1. In embodiments of the invention, aspect ratio may refer to a ratio of width to height or vice-versa of the first electrode 140.

The first electrode 140 formed at the emitter 120 exposed through the contact lines may be electrically and physically coupled to the emitter 120. The first electrode 140 may extend in a predetermined direction and about parallel with other first electrode 140.

The first electrode 140 may collect electric charges moving toward the emitter 120. For example, the first electrode 140 may collect holes. In accordance with an embodiment of the invention, the first electrode 140 may be a finger electrode. Furthermore, the first electrode 140 may be a finger electrode current collector or may be both of the finger electrode and the finger electrode current collector.

In accordance with an embodiment of the invention, the first electrode 140 may be formed of a plating layer. The plating layer may sequentially include a metal seed layer, a diffusion barrier layer, and a conductive layer.

The metal seed layer may be made of a material containing nickel. For example, the metal seed layer may be made of nickel silicide such as Ni₂Si, NiSi, and NiSi₂. The metal seed layer may be formed at a thickness about 50nm to about 200nm.

The thickness of the metal seed layer includes the range from about 50nm to about 200nm because of following reason. When the thickness of the metal seed layer is thinner than about 50nm, it is difficult to form a uniform layer having a high resistance. Accordingly, it is difficult to secure uniformity in a plating process for forming the anti-diffusion layer which may be performed thereafter. When the thickness of the metal seed layer is thicker than about 200nm, the metal seed layer is diffused in to silicon at a constant ratio or rate while forming a nickel silicide layer. Accordingly, shunt leakage may be generated due to the nickel diffusion.

The diffusion barrier layer may be formed on the metal seed layer. The diffusion barrier layer may prevent material of the conductive layer from being diffused to a silicon interface through the metal seed layer. That is, the diffusion barrier layer may prevent junction degradation. The diffusion barrier layer may include nickel formed at a thickness of about 5µm to about 15µm.

The conductive layer may be formed on the diffusion barrier layer. The conductive layer may contain at least one conductive metal material. For example, the conductive metal material may be one selected from a group consisting of nickel (Ni), copper (Cu), silver (Ag), aluminum (Al), tin (Sn), zinc (Zn), indium (In), titanium (Ti), gold (Au), and a combination thereof. However, the conductive layer can be made of another conductive metal material instead of the metal materials described above.

In accordance with an embodiment of the invention, the conductive layer may include a copper layer. The copper layer may function as an electric conductive wire and be formed at a thickness of about 10µm to about 30µm. However, it has been known that copper is easily oxidized in air and it is not easy to directly solder an interconnector, for example, a ribbon, to the copper layer in a modularization process. The interconnector may electrically connect adjacent solar cells.

Accordingly, a tin layer may be further formed on the copper layer in order to prevent the copper layer from being oxidized and to easily solder a ribbon when the conductive layer includes the copper layer. The tin layer may be formed at a thickness of about 5µm to about 15µm.

When the conductive layer is made of other metal instead of the cooper, the tin layer may be omitted when the other metal is not easily oxidized in air and when the other metal can be soldered with ribbon.

When the first electrode 140 is a finger electrode, a current collector may be further formed on the front surface of the substrate 110. The current collector may collect electric charges moving to the finger electrode. The current collector may be formed as a conductive electrode like the first electrode 140. Unlike the first electrode 140, the current collector may be formed by printing, drying, and firing a conductive paste containing a conductive material.

The second electrode 170 may be disposed on a back surface of the substrate 110. The second electrode 170 may collect electric charges moving toward the substrate 110, for example, electrons, and output the collected electric charges to an external device. In accordance with an embodiment of the invention, the second electrode 170 may be a finger electrode. Alternatively, the second electrode 170 may be a finger electrode current collector or may be both of a finger electrode and a finger electrode current collector.

The second electrode 170 may be formed of at least one conductive material selected from a group consisting of aluminum (A), nickel (Ni), copper (Cu), silver (Ag), tin (Sn), zinc (Zn), indium (In), titanium (Ti), gold (Au), and a combination thereof.

The second electrode 170 may be made of a conductive paste containing silver (Ag) particles. Furthermore, the second electrode 170 may be formed as a conductive layer like the first electrode 140.

The second electrode 170 may be formed to have a width about identical to or wider than that of the first electrode 140. When the width of the second electrode 170 is wider than that of the first electrode 140, a line resistance of the second electrode 170 may be reduced.

The BSF unit 150 may be electrically and physically coupled to the second electrode 170. The BSF unit 150 may be disposed on an entire back surface of the substrate 110. The BSF unit 150 may be formed as a region doped with impurities having the same conductive type as the substrate 110 but at a higher concentration. For example, the BSF unit 150 may be formed as n+ region. The BSF unit 150 may have a surface resistance of about 50Ω/sq to about 150Ω/sq.

The BSF unit 150 may form a potential barrier due to an impurity concentration difference with the substrate 110. Accordingly, the BSF unit 150 may disturb holes from moving toward the back surface of the substrate 110. Therefore, the BSF unit 150 may reduce recombination of electrons and holes at the back surface of the substrate 110.

The second antireflection layer 160 may be disposed on a back surface of the BSF unit 150 where the second electrode 170 is not disposed. The second antireflection layer 160 may be made of silicon nitride (SiNx:H) (e.g., hydrogenated silicon nitride).

When light is radiated to the solar cells 10, the light enters into the substrate 110 through the emitter 120 and/or the BSF unit 150. In the substrate 110, electron-hole pairs are generated by the light entering into the substrate 110.

The front surface and/or the back surface of the substrate 110 may have a textured surface. Such textured surface may reduce light reflectively at the front surface and/or the back surface of the substrate 110. Furthermore, light receiving operation and light reflection operation may be repeatedly performed at the textured surface. Therefore, light may be trapped inside the solar cells 10, thereby increasing light absorbance and improving the efficiency of the solar cell 10.

In addition, the first and second antireflection layers 130 and 160 reduce loss of light entering the substrate 110, thereby increasing an amount of light entering into the substrate 110.

The electrons and the holes of electron-hole pairs may be separated by the p-n junction of the substrate 110 and the emitter 120. The electrons may move toward to the substrate 110 having an n conductive type, and the holes may move toward to the emitter 120 having a p conductive type.

The electrons moving toward the substrate 110 may move to the second electrode 170 through the BSF unit 150. The holes moving toward the emitter 120 may move to the first electrode 140.

Therefore, when the first electrode 140 of one solar cell is electrically coupled to the second electrode 170 of an adjacent solar cell through a conductive wire such as an interconnector 20 as shown in FIG. 1, current flows. Such current may be used as electric current for an external device.

Meanwhile, the back substrate 40 may have light transmittance and light reflectivity about equal to or similar to those of the first sealing member 51 or the second sealing member 53 when a bifacial solar cell is used.

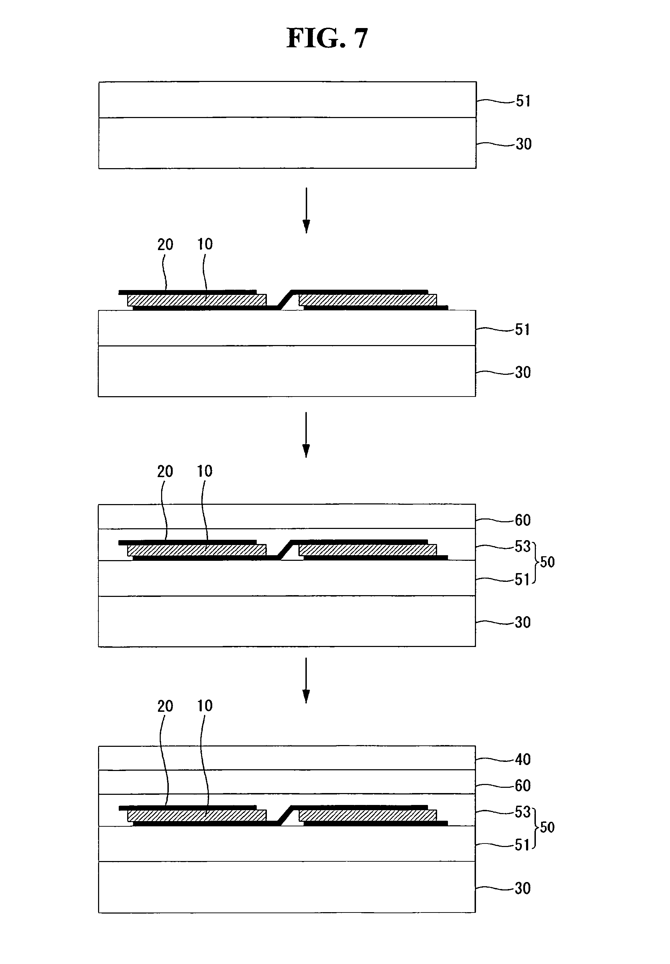

Hereinafter, a method for forming the solar cell module of FIG. 1 will be described with reference to FIG. 7.

At first, a first silicone resin may be coated on one side of the front substrate 30 at a thickness of about 0.3mm to 0.5mm. The coated first silicone resin may be left for about 30 seconds to about 60 seconds for leveling the first silicone resin.

A frame having a predetermined height may be installed to surround the front substrate 30. The frame may prevent the coated first silicone resin from overflowing beyond the front substrate 30.

The front surface with the coated first silicone resin may be placed in an oven. A curing process may be carried out for about 60 second to about 120 seconds at a temperature higher than about 80°C, for example, about 90°C to about 150°C. Accordingly, the first sealing material 51 may be formed by hardening the first silicone resin.

The curing process bonds the first sealing material 51 with the front substrate. An uneven surface may be formed at one surface of the first sealing material 51, which is opposite to a surface bonded to the front substrate.

A plurality of solar cells 10 may be disposed on the first sealing material 51, and a second silicone resin may be coated at a thickness of about 0.3mm to about 0.5mm. The second silicone resin may be left for about 30 seconds to about 60 seconds, thereby leveling the second silicone resin.

Like the first silicone resin, a frame may be installed before coating the liquid second silicone resin.

As a result of coating and leveling the second silicone resin, the liquid second silicone resin may be filled into a space between adjacent solar cells and a space between the solar cells 10 and the first sealing material 51.

After leveling of the second silicone resin, the fiber material 60 may be disposed on the second silicone resin.

As the fiber material 60 is disposed on the second silicone resin liquid, the second silicone resin may be pressurized due to the weight of the fiber material 60, and the space 61 between fibers 63 of the fiber material 60 may be filled with the second silicone resin.

A predetermined pressure may be applied to the fiber material 60 in a top-to-down direction in order to completely fill the space 61 of the individual fibers 63 with the second silicone resin, which later hardens into the second sealing material 53.

The front substrate may be placed in an oven, and a curing process may be carried out at a temperature higher than about 80°C, for example about 90°C to about 150°C, for about 60 seconds to about 120 seconds. As a result, the second sealing material 53 may be formed by hardening the second silicone resin.

The curing process may bond the second sealing material 53 with the first sealing material 51. An uneven surface may be formed at one surface of the second sealing material 53, which is opposite to a surface contacting the first sealing material 51.

A third silicone resin may be coated on the fiber material 60. The third silicone resin may be left for about 30 seconds to about 60 seconds, thereby leveling the third silicone resin.

Like the first and second silicone resins, a frame may be installed before coating the liquid third silicone resin.

If at least one space 61 of the fiber material 60 is not filled with the second sealing material 53, then such an unfilled space 61 may be filled with the third silicone resin. The front substrate 30 may be placed in an oven, and a curing process may be carried out at a temperature higher than about 80°C, for example, about 90°C to about 150°C, for about 60 seconds to about 120 seconds. As a result, the back substrate 40 may be formed by hardening the third silicone resin. The curing process may bond the back substrate 40 with the second sealing material 53.

Although the second silicone resin was described as being hardened after disposing the fiber material 60 on the second silicone resin, the fiber material 60 may be disposed on the second sealing material 53 after the second sealing material 53 is formed by hardening the second silicone resin. Then, the third silicone resin may be coated on the fiber material 60 and hardened.

In this instance, the spaces 61 between individual fibers 63 of the fiber material 60 may be filled with the third silicone resin.

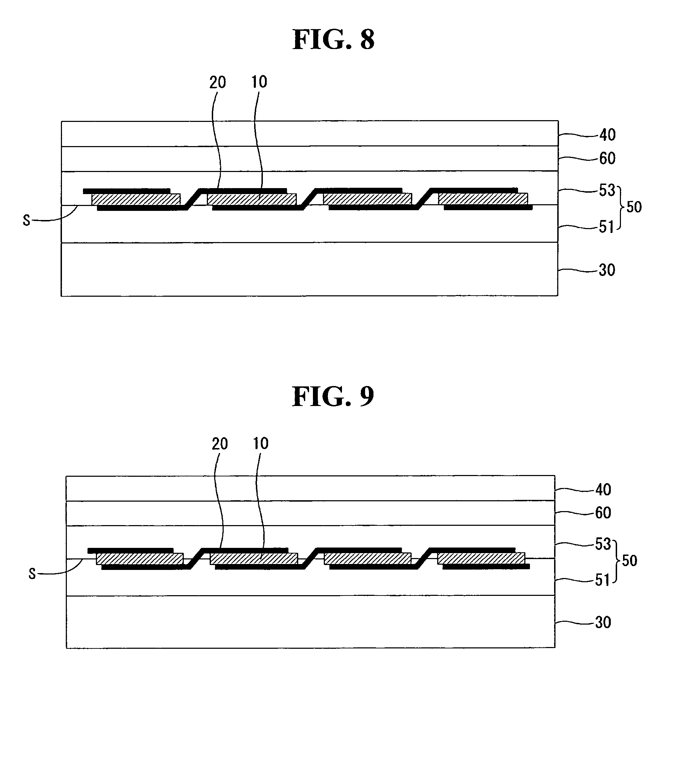

A solar cell module in accordance with modified embodiments of FIG. 1 will be described with reference to FIGS. 8 and 9.

Hereinafter, like numeral references denote like elements in FIG. 1 and FIGS. 8 and 9. Detailed descriptions of like elements that were previously described will be omitted herein.

FIG. 8 illustrates a solar cell module in accordance with a first modified embodiment from the embodiment of FIG. 1, and FIG. 9 illustrates a solar cell module in accordance with second modified embodiment from the embodiment of FIG. 1.

The solar cell modules of FIGS. 8 and 9 may have the same configuration, as compared to that of FIG. 1 except that a part of the solar cell 10 is buried in the first sealing material 51.

FIG. 8 illustrates that an interconnector 20 disposed on a first surface of the solar cell 10 is buried in the first sealing material 51. FIG. 9 illustrates that an interconnector 20 disposed on the first surface of the solar cell 10 and a part of the solar cell 10 are buried in the first sealing material 51.

When the interconnector 20 or the interconnector 20 and the part of the solar cell 10 are buried in the first sealing material 51 as shown in FIGS. 8 and 9, the location of the solar cell 10 may be firmly fixed by the first sealing material 51. Therefore, it may prevent or reduce the disarrangement or misalignment of the solar cells 10 in a modularization process.

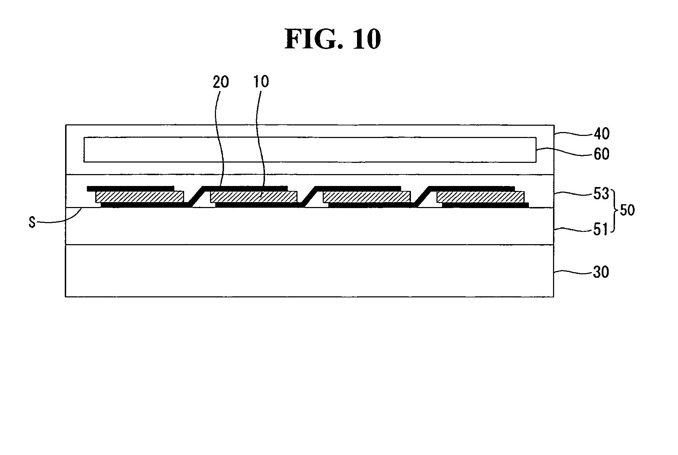

Hereinafter, solar cell modules in accordance with various embodiments of the invention will be described with reference to FIGS. 10 to 13.

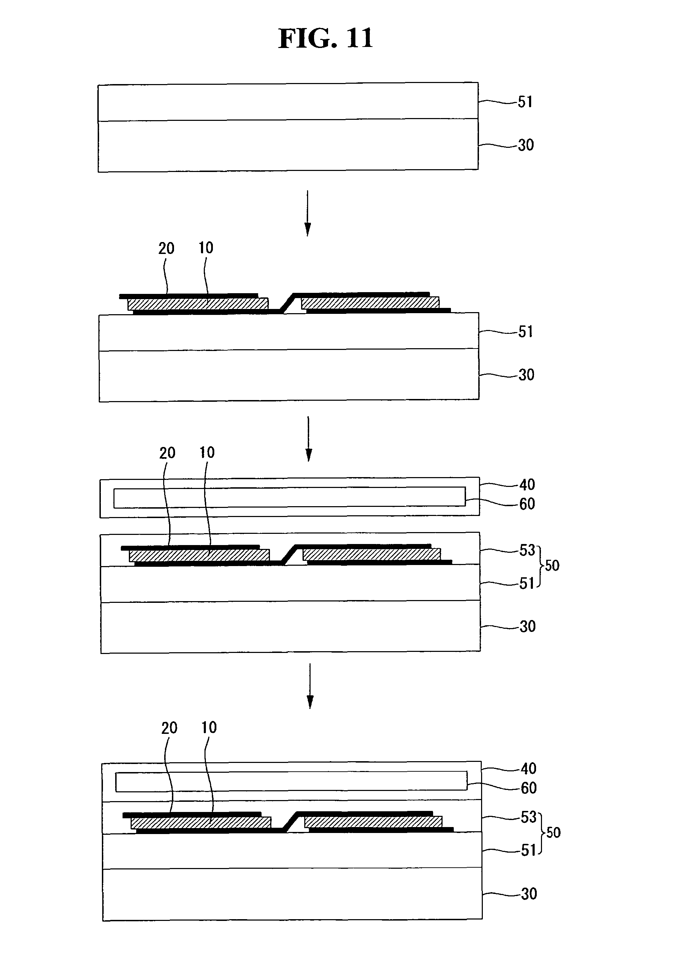

FIG. 10 illustrates a solar cell module in accordance with a second embodiment of the invention. FIG. 11 illustrates a method for manufacturing a solar cell module of FIG. 10.

In accordance with the second embodiment of the invention, the solar cell module of FIG. 10 may have the same configuration of the solar cell module of FIG. 1 except that the back substrate 40 is disposed on the second sealing material 53 and the fiber material 60 is completely buried inside the back substrate 40.

Since the fiber material 60 is completely buried inside the back substrate 40, a top surface, a bottom surface, a left side, and a right side of the fiber material 60 are disposed inside the back substrate 40.

A method of forming the solar cell module of FIG. 10 is shown in FIG. 11. As shown in FIG. 11, the back substrate 40 with the fiber material 60 buried may be formed as a separate part. The back substrate 40 may then be disposed on the second sealing material 53. The back substrate 40 may be bonded to the second sealing material 53 by a typical lamination process. As described above, the back substrate 40 with the fiber material 60 buried may satisfy insulation resistance condition and enhance physical strength of the back substrate 40.

In the instance of forming the back substrate 40 with the fiber material 60 buried as an additional part, a width of the fiber material 60 may be smaller than that of the back substrate 40. The width may be a length of each part, measured in a width direction in FIG. 11.

The fiber material 60 may be disposed after coating the third silicone resin. Then, the third silicone resin may be coated again on the fiber material 60 in order to form the solar cell module of FIG. 10.

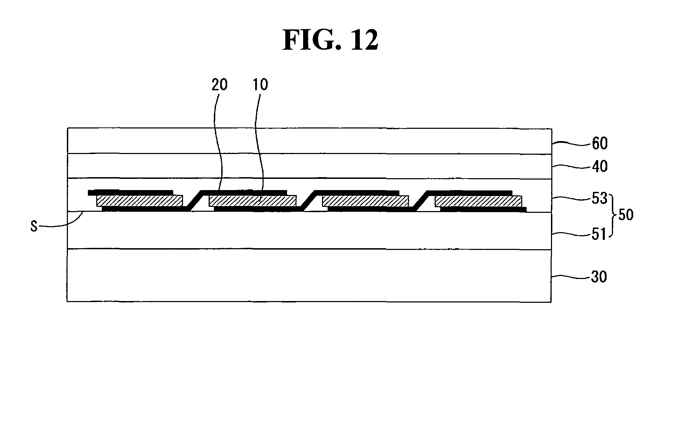

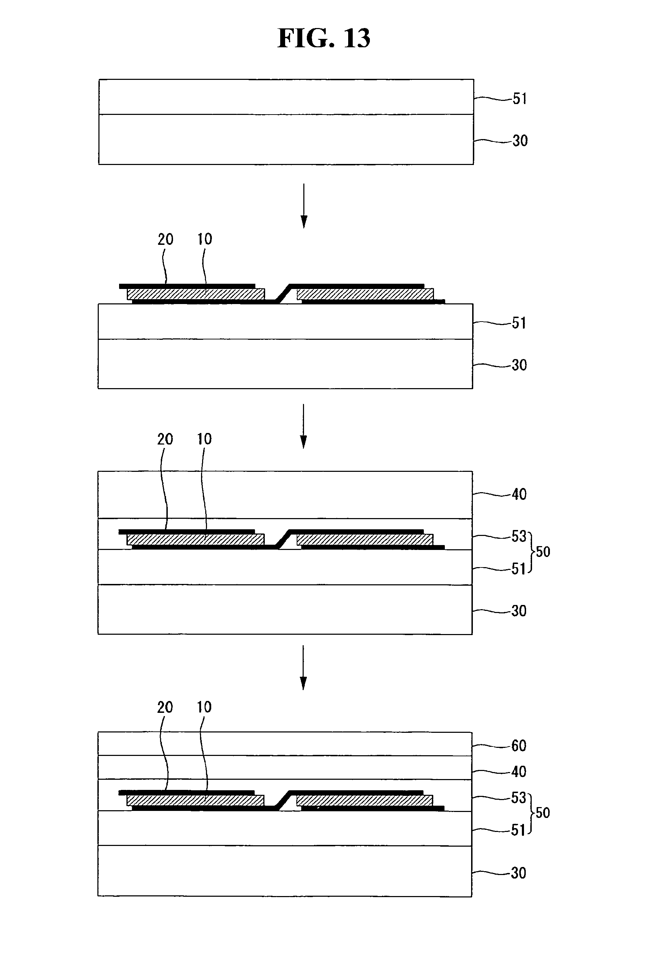

FIG. 12 illustrates a solar cell module in accordance with a third embodiment of the invention. FIG. 13 illustrates a method for forming the solar cell module of FIG. 12.

The solar cell module of FIG. 12 may have the same configuration of the solar cell module of FIG. 1 except that the fiber material 60 is disposed on the back substrate 40.

Unlike the solar cell module of FIG. 1, the solar cell module of FIG. 12 may include the fiber material 60 disposed above the back substrate 40.

FIG. 13 shows a method of forming the solar cell module of FIG. 12. As shown in FIG. 13, the back substrate 40 having the fiber material 60 bonded thereon may be formed as an individual or a separate part. Then, the back substrate 40 may be disposed on the second sealing material 53. The back substrate 40 may be bonded with the second sealing material 53 by performing a typical lamination process.

The solar cell module of FIG. 12 may be formed as follows. The second sealing material 53 may be formed by hardening the second silicone resin. The third silicone resin may be coated on the second sealing material 53. The fiber material 60 may be disposed on the coated third silicone resin. After filling the space 61 between fibers 63 of the fiber material 60, a curing process or a lamination process may be carried out.

The sealing member 50 between the front substrate 30 and the back substrate 40 was described as including the first sealing material 51 and the second sealing material 53. However, the sealing member 50 may include only the first sealing material 51 or only the second sealing material.

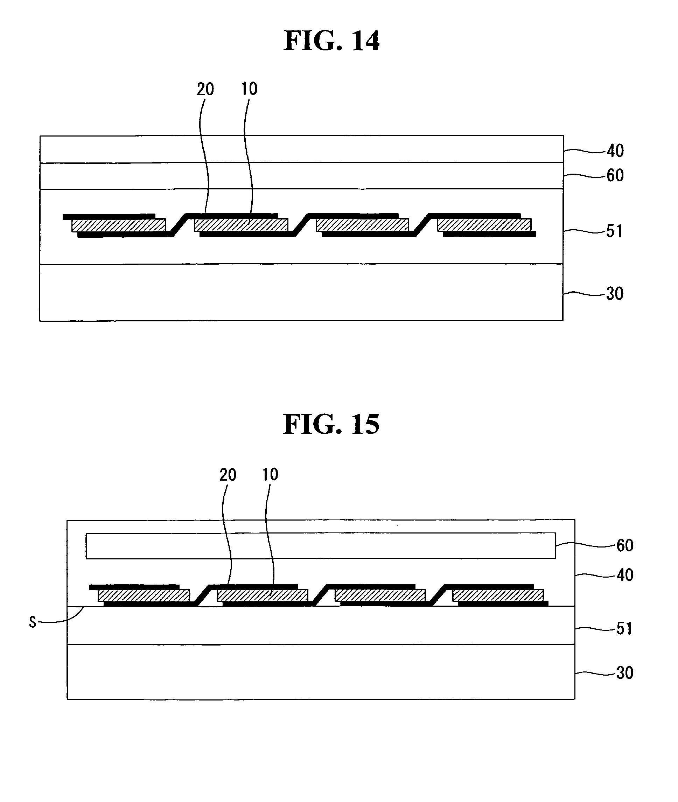

Solar cell modules having different configurations will be described with reference to FIGS. 14 to 16.

FIG. 14 illustrates a solar cell module in accordance with a fourth embodiment of the invention. The solar cell module of FIG. 14 may be formed as follows. The first silicone resin may be coated on one surface of the front substrate 30 at a first time (i.e., a first coating). The solar cells 10 may be disposed on the coated first silicone resin. The first silicone resin may be coated on the solar cells 10 at a second time (i.e., a second coating). A curing process may be carried out to form the first sealing material 51 with the solar cells 10 buried therein. Then, the fiber material 60 may be disposed on the first sealing material 51. The back substrate 40 may be formed by coating and hardening the third silicone resin on the fiber material 60 disposed on the first sealing material 51.

FIG. 15 illustrates a solar cell module in accordance with a fifth embodiment of the invention. The solar cell module of FIG. 15 may be formed by the following processes. The solar cells 10 may be disposed on the first sealing material 51 formed on one surface of the front substrate 30. The third silicone resin may be coated on the solar cells 10 and the first sealing material 51 at a first time (i.e., a first coating). The fiber material may be disposed on the coated third silicone resin. The third silicone resin may be coated on the fiber material at a second time (i.e., a second coating). The secondly coated third silicone resin may be hardened.

In another embodiment of the invention, the fiber material may be disposed after firstly coating the third silicone resin. The back substrate 40 with the fiber material 60 buried therein may be formed by secondly coating the third silicone resin and hardening the secondly coated third silicone resin.

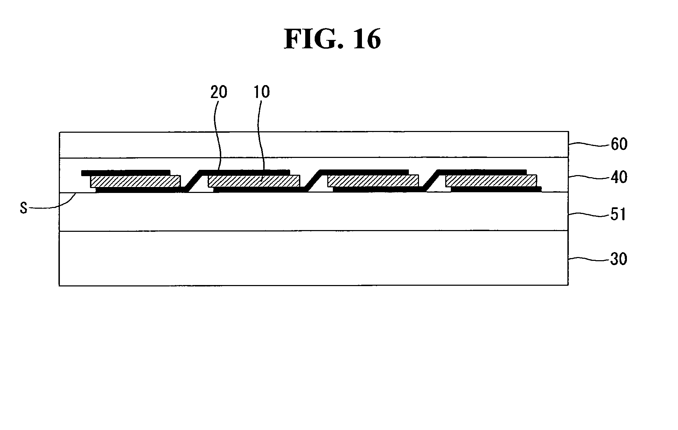

FIG. 16 illustrates a solar cell module in accordance with a sixth embodiment of the invention. The solar cell module of FIG. 16 may be formed by the following processes. The solar cells 10 may be disposed on the first sealing material 51 formed on one surface of the front substrate 30. The third silicone resin may be coated on the solar cells 10 and the first sealing material 51. The fiber material may be disposed on the coated third silicone resin. The space 61 between fibers 63 of the fiber material 60 may be filled with the third silicone resin. Then, the third silicone resin may be hardened.

Meanwhile, a pigment, a dye, and/or a fluorescent material may be dispersed inside at least one of the first sealing material 51, the second sealing material 53, and the back substrate 40. The pigment or the dye may have various colors, and the fluorescent material may emit light when the fluorescent material receives light.

In an embodiment of the invention, when the solar cells 10 are bifacial solar cells, the at least one of the first sealing material 51, the second sealing material 53, and the back substrate 40 may be without the pigment, dye, and/or fluorescent material. In another embodiment of the invention, when the solar cells 10 are bifacial solar cells, the at least one of the first sealing material 51, the second sealing material 53, and the back substrate 40 may include an amount of the pigment, dye, and/or fluorescent material that obtains a light transmittance of about 80% or higher.

In embodiments of the invention, as the sealing member 50 and the back substrate 40 are formed of silicon-based materials, especially silicon resins (i.e., same type of material), adhesive strengths between the sealing member 50 and the back substrate 40 are greater than when they are made of different materials.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A solar cell module comprising:
a plurality of solar cells;
a light transparent front substrate disposed on front surfaces of the plurality of solar cells;
a back substrate disposed on back surfaces of the plurality of solar cells; and
a sealing member disposed between the light transparent front substrate and the back substrate, and having at least one layer of a sealing material,
wherein the back substrate and the sealing member contain silicon-based materials, respectively.

2. The solar cell module of claim 1, wherein the back substrate is made of a first silicone resin and the sealing member is made of a second silicone resin.

3. The solar cell module of claim 2, wherein:
the back substrate is made of organopolysiloxane; and
the sealing member is made of one of polydimethylsiloxane (PDMS) or polydialkylsiloxane (PDAS).

4. The solar cell module of any one preceding claim,
wherein the back substrate has a tensile strength higher than about 30MPa.

5. The solar cell module of any one preceding claim,
wherein the back substrate has a light transmittance lower than about 50% for wavelengths of light of about 300nm to about 500nm.

6. The solar cell module of any one preceding claim,
wherein the back substrate has light reflectance higher than about 40% for wavelengths of light of about 300nm to 500nm.

7. The solar cell module of any one preceding claim,
wherein at least one of the sealing member and the back substrate further includes a fiber material.

8. The solar cell module of claim 7, wherein the fiber material includes fibers formed in a mesh shaped structure, and the fibers are at least one of glass fibers, graphite fibers, nylon fibers, polyester fibers, aramid fibers, polyethylene fibers, polypropylene fibers, and silicon carbide fibers.

9. The solar cell module of claim 7 or 8, wherein a space between the fibers of the fiber material is filled with at least one of the first silicone resin of the back substrate and the second silicone resin of the sealing member.

10. The solar cell module of any one of claims 7 to 9,
wherein the fiber material is disposed inside the sealing member or the back substrate.

11. The solar cell module of any one of claims 7 to 9,
wherein the fiber material is disposed between the sealing member and the back substrate or on the back substrate.

12. The solar cell module of any one of claims 7 to 11, wherein a contact surface between the sealing member and the back substrate is an uneven surface.

13. The solar cell module of any one of claims 7 to 12, wherein the sealing member includes:
a first sealing material disposed between the front substrate and the plurality of solar cells; and
a second sealing material disposed between the plurality of solar cells and the back substrate,
wherein a contact surface of the first sealing material and the second sealing material is an uneven surface.

14. The solar cell module of any one preceding claim, wherein the back substrate contains a white pigment.

15. The solar cell module of claim 14, wherein the sealing member contains the white pigment at a smaller amount than the white pigment contained in the back substrate.
